# EUROPÄISCHE PATENTSCHRIFT

(11) **EP 0 413 110 B1**
(45) Veröffentlichungstag und Bekanntmachung des Hinweises auf die Patenterteilung: **21.06.1995**
(21) Anmeldenummer: 90111967.7
(22) Anmeldetag: 23.06.1990
(51) Int. Cl.: H05K 7/00

(54) **Kühlvorrichtung für elektrische Schaltungsanordnungen**
Cooling device for electric circuit assembly
Dispositif de refroidissement pour ensemble à circuit électrique

(30) Priorität: 18.08.1989 DE 3927324
(43) Veröffentlichungstag der Anmeldung: 20.02.1991
(73) Patentinhaber: LEYBOLD AKTIENGESELLSCHAFT, D-63450 Hanau (DE)
(72) Erfinder: Gesche, Roland, Dr., D-6453 Seligenstadt (DE); Locher, Stefan, D-8755 Alzenau (DE)
(74) Vertreter: Schickedanz, Willi, Dipl.-Ing.

(56) Entgegenhaltungen:
- DE-A- 2 553 614
- DE-C- 508 106
- DE-C- 961 201
- GB-A- 1 188 494
- US-A- 3 518 394

## Beschreibung

Die Erfindung betrifft eine Schaltungsanordnung mit einer Kühlvorrichtung.

Elektrische und elektronische Bauelemente erwärmen sich während des Betriebs aufgrund der auftretenden Verlustleistungen. Die Erwärmung ist dabei in der Regel um so größer, je höher die umgesetzten elektrischen Leistungen sind. Um die Wärme von den betroffenen Bauelementen abzuführen, kommen verschiedene Verfahren zur Anwendung. Bei elektronischen Verstärkern, in denen sich die Leistungstransistoren stark erwärmen, werden beispielsweise Kühlrippen und -schlitze oder Peltier-Kühlelemente verwendet. Diese Kühlverfahren beruhen im Prinzip darauf, die Luft als Wärmeabführmedium zu verwenden. Für eine schnelle und intensive Kühlung reicht die Luft jedoch oft nicht aus. In diesen Fällen greift man auf die bekannte Wasserkühlung zurück, die z. B. bei den meisten Otto-Motoren zur Anwendung kommt.

Ein besonderes Problem stellt die Kühlung von passiven elektrischen Bauelementen wie Spulen und Kondensatoren dar, da diese im Betrieb magnetische oder elektrische Felder erzeugen, welche als Störfelder wirken können. Solche Spulen und Kondensatoren finden beispielsweise in Anpassungsschaltungen für Plasmastrecken Anwendung, wobei diese Anpassungsschaltungen zwischen einem Hochfrequenzgenerator und der Plasmastrecke angeordnet sind (vgl. DE-OS 36 38 880, US-PS 4 207 137, J. Electrochem. Soc. Solid State Science, Bd. 114, Nr. 5, 1967, S. 505 bis 508; J. Vac. Sci. Technol. B 5 (3), Mai/Juni 1987, S. 647). Die in diesen Spulen und Kondensatoren umgesetzten Leistungen betragen oft einige Hundert Kilowatt oder mehr, so daß sich Spulen und Kondensatoren stark erwärmen und u. U. zerstört werden.

Es ist bereits ein Hochfrequenzkabel mit konzentrisch zueinander angeordneten Innen- und Außenleitern bekannt, wobei zwischen Innen- und Außenleiter ein gasförmiges Dieleketrikum umgewälzt wird (DE-AS 16 40 767). Die Probleme, die bei der Kühlung von Spulen und Kondensatoren der Hoehfrequenztechnik auftreten, können mit einem solchen Kabel jedoch nicht gelöst werden.

Es ist außerdem ein flüssigkeitsgekühlter Widerstand mit einem Widerstandskörper bekannt, der in einem rohrförmigen, mit einem Strömungskanal für die Kühlflüssigkeit versehenen Gehäuse angeordnet ist (DE-OS 25 53 614). Hierbei ist der aus Stahl oder Kupfer gefertigte Strömungskanal wendelartig um den Widerstandskörper geführt, so daß dieser gut gekühlt werden kann. Der wendelartige Strömungskanal selbst dient hierbei jedoch nicht als Spule, d. h. er wird nicht von elektrischen Strömen durchflossen.

Weiterhin ist ein Induktanz-System für die Hochfrequenz-Übertragung bekannt, bei dem die Versorgung eines zirkulierenden Kühlmediums mit der Induktanz verbunden ist, wobei diese Induktanz konzentrisch gewundene Rohre aus Metall aufweist, die übereinander angeordnet sind (US-PS 1 817 247). An diese Induktanz ist ein Wasserzuführungsschlauch aus Gummi angeschlossen, der als Abbaustrecke dient. Die Abbaustrecke ist erforderlich, weil wenigstens ein Anschluß der Induktanz ein Potential gegenüber Masse besitzt, so daß die ein- und ausfließende Kühlflüssigkeit ebenfalls an Spannung liegt und somit einen Wirkwiderstand darstellt. Dieser Wirkwiderstand muß möglichst groß sein, damit der Wirkungsgrad der Schaltung nicht wesentlich verschlechtert wird und thermische Beschädigungen des Kühlwasserschlauchs vermieden werden. Andererseits sollen aber auch die Verluste, die durch das Einkoppeln der HF-Felder in das Kühlwasser entstehen, möglichst gering gehalten werden. Beide Forderungen können nur mit langen Schläuchen, die wenig Wasser führen, erfüllt werden, was jedoch keine optimale Lösung darstellt.

Um den Abfluß von Hochfrequenzleistung zu verringern, ist es auch bekannt, die wasserzuführenden Gummischläuche als spiralige Drosseln auszubilden (DE-PS 508 106, DE-PS 562 318).

In der Hochfrequenztechnik ist ebenfalls bekannt, Anfang und Ende einer Kühlwasserleitung an Erdpotential zu legen (DE-PS 551 100). Um die entstehenden Hochfrequenzverluste zu vermindern, wird dafür gesorgt, daß das Umgebungspotential längs der Wassersäule gleichmäßig abfällt. Dies wird dadurch erreicht, daß die Kühlleitung von einer Drahtspule umgeben ist, die mit dem zu kühlenden Anschluß und Erde in Verbindung steht. Bei dieser bekannten Kühlwasserleitung handelt es sich jedoch nicht um eine koaxiale Leitung, sondern um ein einfaches Rohr, so daß das Kühlwasser mittels eines separaten Schlauchs an dieses Rohr herangeführt werden muß.

Der Erfindung liegt die Aufgabe zugrunde, elektrische Bauelemente wirksam zu kühlen und gleichzeitig eine hochohmige Belastung des elektrischen Anschlusses zu erreichen, ohne große elektrische Verluste auftreten zu lassen.

Diese Aufgabe wird gemäß den Merkmalen des Patentanspruchs 1 gelöst.

Der mit der Erfindung erzielte Vorteil besteht insbesondere darin, daß Anpassungsschaltungen und ähnliche Schaltungen bei hohem Wirkungsgrad klein und kostengünstig aufgebaut werden können. Es treten keine Wasserabbaustrecken auf, so daß die Leitfähigkeit des Kühlwassers nicht beeinflußt wird.

Dadurch, daß sowohl die Hin- als auch die Rückleitung der Kühlflüssigkeit durch eine metallische Wand abgeschirmt sind, können keine Hochfrequenzfelder in das Wasser eindringen, und zwar auch dann nicht, wenn das innere Rohr der koaxialen Kühlleitung aus einem Kunststoffschlauch besteht. Ein besonderer Vorteil der Erfindung besteht auch darin, daß sich eine sehr kompakte Kondensator/Spulen-Anordnung aufbauen läßt, indem der Kondensator in den Spulenraum eingeführt und von diesem mitgekühlt wird.

Ausführungsbeispiele sind in der Zeichnung dargestellt und werden im folgenden näher beschrieben. Es zeigen:
- Fig. 1: eine Ansicht auf die Längsseite des Gehäuses einer Anpassungsschaltung;
- Fig. 2: eine geschnittene Ansicht der Schmalseite des Gehäuses einer Anpassungsschaltung;
- Fig. 3: eine geschnittene Ansicht auf die längsseite des Gehäuses einer Anpassungsschaltung;
- Fig. 4: eine erste Anpassungsschaltung, bei welcher die erfindungsgemäße Kühlvorrichtung eingesetzt werden kann;
- Fig. 5: eine zweite Anpassungsschaltung, bei welcher die erfindungsgemäße Kühlvorrichtung eingesetzt werden kann;
- Fig. 6: eine Detaildarstellung einer wassergekühlten Spule;
- Fig. 7: eine weitere Detaildarstellung einer wassergekühlten Spule.

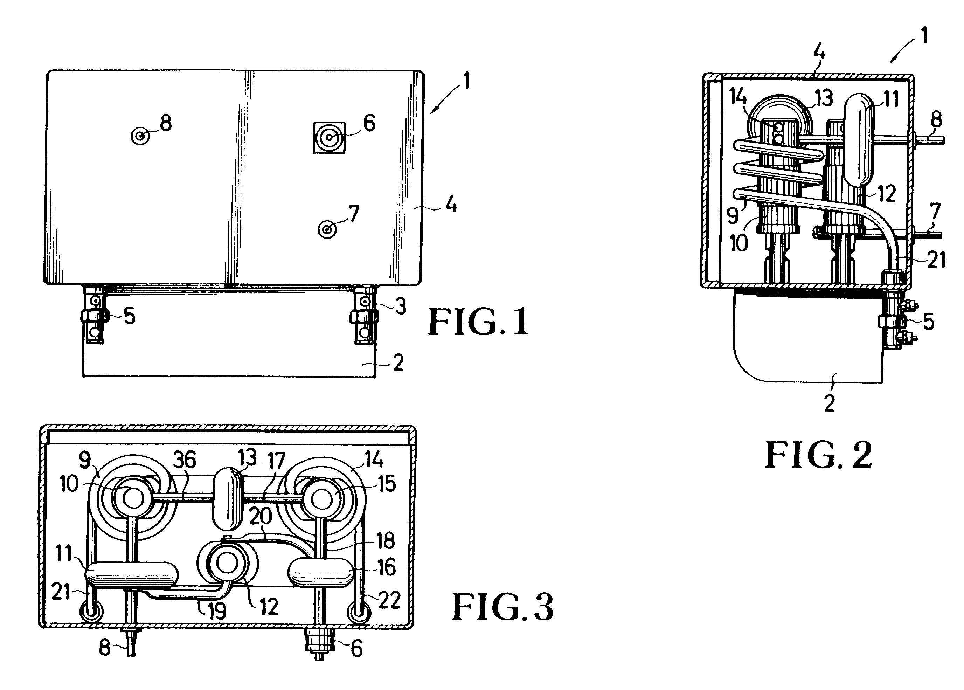

In der Fig. 1 ist ein Gehäuse 1 dargestellt, in dem sich eine wassergekühlte Anpassungsschaltung befindet. Dieses Gehäuse weist auf seiner Unterseite einen Behälter 2 auf, vor dem ein elektrischer Anschlußstutzen 3 vorgesehen ist, der in den Oberteil 4 des Gehäuses 1 führt. Ein zweiter elektrischer Anschlußstutzen 5 ist in einem vorgegebenen Abstand von dem ersten Anschlußstutzen 3 angeordnet. Mit diesen Anschlußstutzen 3, 5 ist beispielsweise eine in der Fig. 1 nicht dargestellte Plasmastrecke verbunden, d. h. die Anschlußstutzen stellen gewissermaßen den Ausgang eines Anpassungs-Vierpols dar. Den Eingang dieses Vierpols, der an einem nicht dargestellten Hochfrequenzgenerator liegt, stellen die Anschlüsse 6, 7 auf der Frontseite des Oberteils 4 dar.

Die Fig. 2 zeigt das in der Fig. 1 dargestellte Gehäuse 1 im Schnitt und mit Ansicht auf die Schmalseite. Man erkennt hierbei eine Spule 9, die ein Element eines Parallelschwingkreises darstellt. Das andere Element dieses Parallelschwingkreises, ein variabler Kondensator 10, ist innerhalb dieser Spule 9 angeordnet. Es handelt sich hierbei um einen Vakuum-Kondensator in zylindrischer Form, der als solcher bekannt ist (DE-PS 491 342). Mit der Bezugszahl 11 ist ein Reihenkondensator bezeichnet, der im Längszweig der Anpassungsschaltung und an einem Anschluß 8 liegt. Ein weiterer variabler Kondensator 12 zur Auskopplung einer Biasspannung ist rechts neben dem Kondensator 10 angeordnet. Ein Reihenkondensator 13, der wie der Reihenkondensator 11 im Längszweig der Anpassungsschaltung angeordnet ist, ist über eine Leitung 36 mit dem variablen Kondensator 10 verbunden.

In der Fig. 3 ist eine Draufsicht auf die Anpassungsschaltung gezeigt, welche neben der Parallelspule 9 eine weitere Parallelspule 14 enthält, in der sich ein Parallelkondensator 15 befindet. Dieser parallelkondensator ist mit einem Reihenkondensator 16 verbunden, der an dem Anschluß 6 liegt. Zwischen den Kondensatoren 13 und 15 sowie zwischen den Kondensatoren 15 und 16 sind elektrische Verbindungsleitungen 17, 18 vorgesehen. Weitere elektrische Verbindungsleitungen 19, 20 führen vom Kondensator 11 zum Kondensator 12 bzw. vom Kondensator 12 zum Kondensator 16.

Das Ende 21 der Spule 9 ist mit dem Anschlußstutzen 5 verbunden, der in der Fig. 3 nicht zu erkennen ist. Entsprechendes gilt für das Ende 22 der Spule 4, das an dem Anschlußstutzen 3 liegt.

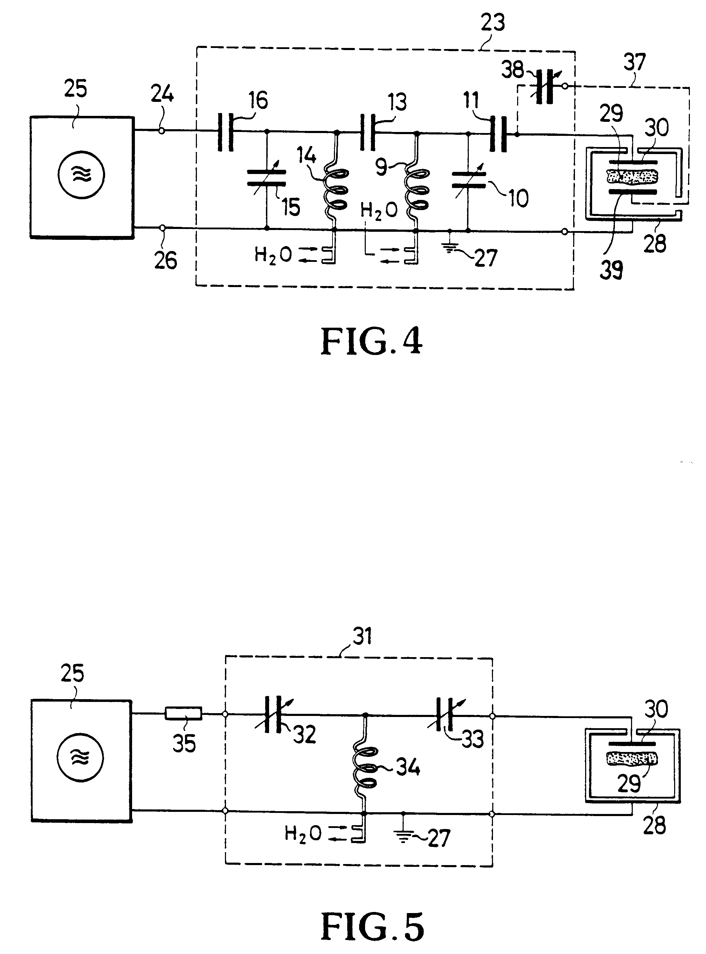

Die gesamte Anpassungsschaltung 23 ist in der Fig. 4 noch einmal als Schaltbild dargestellt. Man erkennt hierbei, daß der Kondensator 16 an einem Ausgang 24 eines Hochfrequenzoszillators 25 liegt, dessen zweiter Ausgang 26 an Masse 27 und an das Gehäuse 28 einer Plasmakammer angeschlossen ist, in der sich das Plasma 29 befindet. Dem Kondensator 16 ist ein Parallelschwingkreis 15, 14 nachgeschaltet, der den variablen Kondensator 15 enthält. Auf diesen Parallelschwingkreis 15, 14 folgt der Längskondensator 13, dem wiederum ein Parallelschwingkreis 9, 10 nachgeschaltet ist. Zwischen diesem Parallelschwingkreis 9, 10 und einer Elektrode 30 der Plasmakammer befindet sich der Längskondensator 11. Die Spulen 9 und 14 sind als gekühlte Koaxialrohre dargestellt. Im Biasbetrieb, der durch die gestrichelte Leitung 37 angedeutet ist, wird eine weitere Elektrode 39, die meist durch den Substratteller realisiert wird, in der Vakuumkammer mit einem Teil der HF-Leistung betrieben. Ein Bias-Kondensator 38 dient also dazu, einen weiteren regelbaren Ausgang für einen Teil der HF-Leistung zu erhalten.

In der Fig. 5 ist eine weitere Anpassungsschaltung 31 dargestellt, die zwei variable Kondensatoren 32, 33 im Längszweig und eine feste Spule 34 im Querzweig enthält. Mit der Bezugszahl 35 ist die Ausgangsimpedanz des Hochfrequenzgenerators 25 bezeichnet. Einzelheiten dieser Anpassungsschaltung sind in der deutschen Patentanmeldung P 38 21 134.3-33 beschrieben. Die Spule 34 ist in der Fig. 5 als wassergekühlte Spule dargestellt.

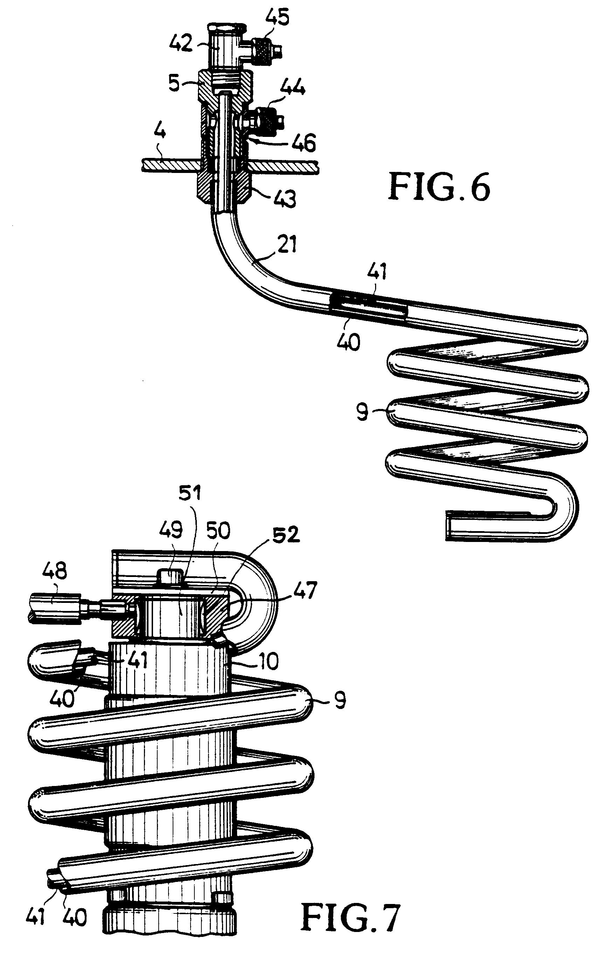

Die Fig. 6 zeigt die Spule 9 der Fig. 2 noch einmal im Detail, wobei ein äußeres Rohr 40 und ein inneres Rohr 41 zu erkennen sind. Die Induktivität wird durch das äußere Rohr des Koaxialsystems 40, 41 gebildet. Der elektrische Anschluß wird durch die Verschraubung 5 mit dem Gehäuse 4 und durch das Verbindungsstück zu den Kondensatoren hergestellt. Das innere Rohr 41 hat keine elektrische Funktion, sondern dient nur zum Transport des Kühlwassers. Das Kühlwasser wird über einen Anschlußstutzen 42 zu- und abgeleitet. Weitere Verbindungselemente, die für die Erfindung nicht von Bedeutung sind, sind mit den Bezugszahlen 43 bis 46 versehen.

In der Fig. 7 ist eine Kombination aus Spule 9 und Kondensator 10 dargestellt, wobei sich der Kondensator 10 innerhalb der Spule 9 befindet. Hierbei handelt es sich um eine besonders kompakte Bauweise. Der Kondensator weist in seinem oberen Bereich einen zylindrischen Stutzen 51 auf, um den ein Kontaktring 47 gelegt ist. Auf dem Stutzen 51 liegt ein Flansch 50, über den der Kondensator 10 mittels einer Schraube 49 oder einem anderen geeigneten Verbindungselement mit dem Ende der Spule 9 verbunden ist. In einer Aussparung des Kontaktrings 47, die den Stutzen 51 umgibt, ist ein bogenförmiger elektrischer Kontakt 52 vorgesehen, der mit einer elektrischen Zuführung 48 in Verbindung steht.

Somit wird über die Zuführung 48 und den Kontakt 52 elektrisches Potential an den Stutzen 51 des Kondensators 10 herangeführt und gleichzeitig über den Kontaktring 47 und den Flansch 50 die Wärme des Kondensators 10 auf das Ende der Spule 9 abgeführt.

## Patentansprüche

1. Schaltungsanordnung der Hochfrequenztechnik mit einer Kühlvorrichtung, wobei die Kühlvorrichtung, mit zwei wenigstens teilweise koaxial zueinander angeordneten Rohren versehen ist, von denen wenigstens das äußere Rohr (40) aus einem metallischen Material besteht, wobei in dem inneren Rohr (41) eine Kühlflüssigkeit in eine erste Richtung strömt und in den Raum zwischen dem inneren Rohr und dem äußeren Rohr die Kühlflüssigkeit in eine zweite Richtung strömt und wobei das äußere Rohr an einem elektrischen Potential liegt, **dadurch gekennzeichnet**, daß das äußere Rohr (40) an der Stelle, an der die Kühlflüssigkeit in ein Bauelement (14, 10) hinein- bzw. herausfließt, an Masse (27) liegt.

2. Schaltungsanordnung nach Anspruch 1, **dadurch gekennzeichnet**, daß sowohl das innere Rohr (41) als auch das äußere Rohr (40) aus Metall sind.

3. Schaltungsanordnung nach Anspruch 1, **dadurch gekennzeichnet**, daß das innere Rohr (41) aus Kunststoff und das äußere Rohr (40) aus Metall besteht.

4. Schaltungsanordnung nach Anspruch 1, **dadurch gekennzeichnet**, daß das äußere Rohr (40) eine Spulenwicklung bildet.

5. Schaltungsanordnung nach Anspruch 1, **dadurch gekennzeichnet,** daß das Bauelement ein Vakuum-Kondensator (10, 15) von zylindrischer Form ist und die Außenwand des Kondensators parallel von der Innenwand des inneren Rohrs mit einem Abstand umgeben ist, so daß zwischen dem äußeren Rohr und dem inneren Rohr eine Kühlflüssigkeit in einer ersten Richtung und zwischen dem inneren Rohr und der Außenwand des Kondensators die Kühlflüssigkeit in einer zweiten Richtung fließt.

6. Schaltungsanordnung nach Anspruch 1, **dadurch gekennzeichnet**, daß das Bauelement eine Hochfrequenzröhre ist.

7. Schaltungsanordnung nach Anspruch 1, **dadurch gekennzeichnet**, daß ein erstes Bauelement eine Spule (9) und ein zweites Bauelement ein Kondensator (10) ist und daß sich der Kondensator (10) in dem durch die Spulenwindungen aufgebauten Raum befindet.

8. Schaltungsanordnung nach Anspruch 4, **dadurch gekennzeichnet**, daß die Spule (9, 14, 34) zylindrisch gewickelt ist und einen runden Leiterquerschnitt aufweist.

9. Schaltungsanordnung nach Anspruch 1, **dadurch gekennzeichnet**, daß das Bauelement Bestandteil einer Anpassungsschaltung (12) für eine Plasmastrecke (29) mit einem Hochfrequenzgenerators (25) ist, wobei die Anpassungsschaltung (12) einen Kondensator (16) im Längszweig, einen ersten Parallelschwingkreis (14, 15) im Querzweig, einen zweiten Kondensator (13) im Längszweig, einen zweiten Parallelschwingkreis (9, 10) im Querzweig und einen dritten Kondensator (11) im Längszweig aufweist.

10. Schaltungsanordnung nach Anspruch 9, **dadurch gekennzeichnet**, daß die Kondensatoren (10, 15) der Parallelschwingkreise (14, 15; 10, 9) variable Vakuum-Kondensatoren sind, die sich in den Spulen (9, 14) der Parallelschwingkreise (14, 15; 10, 9) befinden.

11. Schaltungsanordnung nach Anspruch 1, **dadurch gekennzeichnet**, daß ein weiterer variabler Kondensator (38) zur Auskopplung einer Biasspannung vorgesehen ist.

12. Schaltungsanordnung nach Anspruch 9, **dadurch gekennzeichnet**, daß die Anpassungsschaltung (31) ein T-Glied ist.

13. Schaltungsanordnung nach Anspruch 9, **dadurch gekennzeichnet**, daß zwischen dem einen Ausgangsanschluß des Hochfrequenzgenerators (25) und der einen Elektrode (30) der Plasmastrecke (29) zwei variable Längskondensatoren (32, 33) angeordnet sind, von denen der eine Längskondensator (32) direkt mit dem Ausgangsanschluß des Hochfrequenzgenerators (25) verbunden ist, während der andere Längskondensator (33) direkt mit der einen Elektrode (30) der Plasmastrecke (29) in Verbindung steht, daß eine Querspule (34) vorgesehen ist, die mit ihrem einen Anschluß an die Verbindungsleitung zwischen den Kondensatoren (32, 33) angeschlossen ist und mit ihrem anderen Anschluß sowohl mit dem Hochfrequenzgenerator (25) als auch mit der anderen Elektrode (28) der Plasmastrecke (29) in Verbindung steht.

14. Schaltungsanordnung nach Anspruch 1, **dadurch gekennzeichnet**, daß das Bauelement (10) ein Kondensator ist, dessen Wärme auf einen Kontaktring (47) übertragen wird, der mit dem Ende einer flüssigkeitsgekühlten Spule (9) verbunden ist.

15. Schaltungsanordnung für Bauelemente der Hochfrequenztechnik, **gekennzeichnet durch** einen Kondensator (10), der von einer flüssigkeitsdurchströmten, koaxialen Spule (9, 40, 41) umgeben ist, wobei an einer Spannungszuführung (48) zu dem Kondensator (10) ein Kontaktring (47) vorgesehen ist, der die Wärme des Kondensators auf die Außenwand (40) der Spule (9) überträgt.

16. Schaltungsanordnung nach Anspruch 14 oder 15, **dadurch gekennzeichnet**, daß der Kontaktring (47) mit einer elektrischen Zuführung (48) in Verbindung steht und über einen Flansch (50) mit einer Seite der Spule (9) verbunden ist.

## Claims

1. Circuit arrangement for high-frequency technology with a cooling device, wherein the cooling device is provided with two tubes which are disposed at least partially coaxially with respect to one another and of which at least the outer tube (40) is made from a metallic material, wherein a cooling fluid flows in a first direction in the inner tube (41) and the cooling fluid flows in a second direction in the space between the inner tube and the outer tube, and wherein the outer tube is connected to an electric potential, characterised in that the outer tube (40) is connected to earth (27) at the point at which the cooling fluid flows into or out of a component (14, 10).

2. Circuit arrangement according to Claim 1, characterised in that both the inner tube (41) and the outer tube (40) are made from metal.

3. Circuit arrangement according to Claim 1, characterised in that the inner tube (41) is made from plastics material and the outer tube (40) from metal.

4. Circuit arrangement according to Claim 1, characterised in that the outer tube (40) forms a coil winding.

5. Circuit arrangement according to Claim 1, characterised in that the component is a vacuum capacitor (10, 15) of cylindrical shape and the outer wall of the capacitor is surrounded by the inner wall of the inner tube in a parallel manner and with a clearance, so that a cooling fluid flows in a first direction between the outer tube and the inner tube and the cooling fluid flows in a second direction between the inner tube and the outer wall of the capacitor.

6. Circuit arrangement according to Claim 1, characterised in that the component is a high-frequency tube.

7. Circuit arrangement according to Claim 1, characterised in that a first component is a coil (9) and a second component is a capacitor (10) and that the capacitor (10) is located in the space formed by the coil windings.

8. Circuit arrangement according to Claim 4, characterised in that the coil (9, 14, 34) is wound cylindrically and has a round conductor cross-section.

9. Circuit arrangement according to Claim 1, characterised in that the component is a constituent part of an adapting circuit (12) for a plasma section (29) with a high-frequency generator (25), wherein the adapting circuit (12) has a capacitor (16) in the long arm, a first parallel resonant circuit (14, 15) in the cross arm, a second capacitor (13) in the long arm, a second parallel resonant circuit (9, 10) in the cross arm and a third capacitor (11) in the long arm.

10. Circuit arrangement according to Claim 9, characterised in that the capacitors (10, 15) of the parallel resonant circuits (14, 15; 10, 9) are variable vacuum capacitors which are located in the coils (9, 14) of the parallel resonant circuits (14, 15; 10, 9).

11. Circuit arrangement according to Claim 1, characterised in that a further capacitor (38) is provided for decoupling a bias voltage.

12. Circuit arrangement according to Claim 9, characterised in that the adapting circuit (31) is a T element.

13. Circuit arrangement according to Claim 9, characterised in that between one output connection of the high-frequency generator (25) and one electrode (30) of the plasma section (29) there are disposed two variable longitudinal capacitors (32, 33), of which one longitudinal capacitor (32) is connected directly to the output connection of the high-frequency generator (25), whilst the other longitudinal capacitor (33) is directly connected to one electrode (30) of the plasma section (29), that a transverse coil (34) is provided which is connected with one of its connections to the connecting line between the capacitors (32, 33) and with its other connection both to the high-frequency generator (25) and to the other electrode (28) of the plasma section (29).

14. Circuit arrangement according to Claim 1, characterised in that the component (10) is a capacitor, the heat from which is transferred to a contact ring (47) which is connected to the end of a fluid-cooled coil (9).

15. Circuit arrangement for components in high-frequency technology, characterised by a capacitor (10) which is surrounded by a coaxial coil (9, 40, 41) through which fluid flows, wherein a contact ring (47) which transfers the heat of the capacitor to the outer wall (40) of the coil (9) is provided on a voltage supply (48) to the capacitor (10).

16. Circuit arrangement according to Claim 14 or 15, characterised in that the capacitor (47) is connected to an electrical supply (48) and is connected by a flange (50) to one side of the coil (9).

## Revendications

1. Circuit employé dans le domaine de la haute fréquence, équipé d'un dispositif de refroidissement, le dispositif de refroidissement étant pourvu de deux tubes, au moins partiellement coaxiaux l'un par rapport à l'autre, parmi lesquels au moins le tube extérieur (40) est constitué en un matériau métallique, un liquide de refroidissement s'écoulant dans une première direction à l'intérieur du tube intérieur (41) et, dans l'espace situé entre le tube intérieur et le tube extérieur, le liquide de refroidissement s'écoulant dans une deuxième direction, et le tube extérieur se trouvant à un potentiel électrique, caractérisé en ce que le tube extérieur (40) est à la masse (27) à l'endroit où le liquide de refroidissement pénètre dans ou s'écoule hors d'un composant (14, 10).

2. Circuit selon la revendication 1, caractérisé en ce que le tube intérieur (41) et le tube extérieur (40) sont tous deux constitués en métal.

3. Circuit selon la revendication 1, caractérisé en ce que le tube intérieur (41) est constitué en matière synthétique et le tube extérieur (40) est constitué en métal.

4. Circuit selon la revendication 1, caractérisé en ce que le tube extérieur (40) forme un enroulement de bobine.

5. Circuit selon la revendication 1, caractérisé en ce que le composant est un condensateur à vide (10, 15) de forme cylindrique et la paroi extérieure du condensateur est entourée, de façon parallèle et à distance, par la paroi intérieure du tube intérieur, de telle sorte qu'un liquide de refroidissement s'écoule entre le tube extérieur et le tube intérieur, dans une première direction, et, entre le tube intérieur et la paroi extérieure du condensateur, dans une deuxième direction.

6. Circuit selon la revendication 1, caractérisé en ce que le composant est un tube haute fréquence.

7. Circuit selon la revendication 1, caractérisé en ce qu'un premier composant est une bobine (9) et un deuxième composant est un condensateur (10), et en ce que le condensateur (10) est situé dans l'espace formé par les spires de la bobine.

8. Circuit selon la revendication 4, caractérisé en ce que la bobine (9, 14, 34) est enroulée de façon cylindrique et présente une section de conducteur ronde.

9. Circuit selon la revendication 1, caractérisé en ce que le composant fait partie d'un circuit d'adaptation (12) destiné à une trajectoire de plasma (29) avec un oscillateur haute fréquence (25), le circuit d'adaptation (12) présentant un condensateur (16) dans sa branche longitudinale, un premier circuit oscillant parallèle (14, 15) dans sa branche transversale, un deuxième condensateur (13) dans sa branche longitudinale, un deuxième circuit oscillant parallèle (9, 10) dans sa branche transversale et un troisième condensateur (11) dans sa branche longitudinale.

10. Circuit selon la revendication 9, caractérisé en ce que les condensateurs (10, 15) des circuits oscillants parallèles (14, 15 ; 10, 9) sont des condensateurs à vide variables, qui se trouvent dans les bobines (9, 14) des circuits oscillants parallèles (14, 15 ; 10, 9).

11. Circuit selon la revendication 1, caractérisé en ce qu'est prévu un autre condensateur variable (38) pour le découplage d'une tension de dérivation.

12. Circuit selon la revendication 9, caractérisé en ce que le circuit d'adaptation (31) est un réseau en T.

13. Circuit selon la revendication 9, caractérisé en ce que sont situés, entre le raccord de sortie de l'oscillateur haute fréquence (25) et l'électrode (30) de la trajectoire de plasma (29), deux condensateurs longitudinaux (32, 33) variables, dont l'un (32) est directement relié au raccord de sortie de l'oscillateur haute fréquence (25), tandis que l'autre condensateur longitudinal (33) est relié directement à l'électrode (30) de la trajectoire de plasma (29), en ce qu'une bobine transversale (34) est prévue et est branchée, par l'un de ses raccords, sur la conduite de liaison entre les condensateurs (32, 33) et est reliée, par son autre raccord, aussi bien avec l'oscillateur haute fréquence (25) qu'avec l'autre électrode (28) de la trajectoire de plasma (29).

14. Circuit selon la revendication 1, caractérisé en ce que le composant (10) est un condensateur, dont la chaleur est transmise à un anneau de contact (47) qui est relié avec l'extrémité d'une bobine (9) refroidie par un liquide.

15. Circuit destiné à des composants utilisés dans le domaine de la haute fréquence, caractérisé par un condensateur (10) entouré d'une bobine (9, 40, 41) coaxiale, traversée par un liquide, un anneau de contact (47) étant prévu sur une alimentation de tension (48) vers le condensateur (10), anneau qui transmet la chaleur du condensateur à la paroi extérieure (40) de la bobine (9).

16. Circuit selon la revendication 14 ou 15, caractérisé en ce que l'anneau de contact (47) est en liaison avec une alimentation électrique (48) et est relié, par l'intermédiaire d'une bride (50), avec un côté de la bobine (9).
